# EUROPEAN PATENT APPLICATION

(11) **EP 1 271 479 A2**
(43) Date of publication of application: **02.01.2003**
(21) Application number: 02253884.7
(22) Date of filing: 31.05.2002
(51) Int. Cl.: G11B 5/596

(54) **A data code and method for coding data**

(30) Priority: 28.06.2001 US 301506 P; 05.11.2001 US 994009
(71) Applicant: STMicroelectronics, Inc., Carrollton, TX 75006-5039 (US)
(72) Inventor: Heydari, Fereidoon, Cupertino, California 95014 (US); Ozdemir, Hakan, San Jose, California 95008 (US)
(74) Representative: Style, Kelda Camilla Karen

(57) **Abstract**

A new technique incorporates a 1/4-rate Hard Disk Drive (HDD) servo-data encoding into a Partial Response Maximum Likelihood (PRML) read channel. The limitation of the HDD servo-track writer is the maximum frequency associated with writing the servo data while maintaining a level of data alignment between the data in the adjacent tracks (coherency). The 1/4 code allows the servo data to be written at the maximum coherency bandwidth. Specifically, the data is read back (or sampled) at twice the write frequency. This increases the data redundancy while also increasing the data density and the disk storage capacity. The 1/4 coding can also be applied to conventional HDD dibit coding. Specifically, the 1/4-coding scheme reads each dibit-coded servo-data transition 01 as 0011, and reads each non-transition 00 (or 0) as 0000. The 1/4 coding and its matched Viterbi detector can also increase the data detection in comparison to conventional peak-detection schemes. And although the 1/4 coding scheme is described in conjunction with a PR4-type servo channel, it can also be used with an EPR4-type servo channel and other types of servo channels.

## Description

This application is related to commonly owned U.S. Patent App. Ser. Nos. 60/301505 and 09/993877 entitled "DATA STORAGE DISK HAVING FEW OR NO SPIN-UP WEDGES AND METHOD FOR WRITING SERVO WEDGES ONTO THE DISK", 60/301504 and 09/993876 entitled "CIRCUIT AND METHOD FOR DETECTING A SERVO WEDGE ON SPIN UP OF A DATA-STORAGE DISK", 60/301469 and 09/993869 entitled "CIRCUIT AND METHOD FOR DETECTING A SPIN-UP WEDGE AND A CORRESPONDING SERVO WEDGE ON SPIN UP OF A DATA-STORAGE DISK", 60/301489 and 09/993986 entitled "CIRCUIT AND METHOD FOR DEMODULATING A SERVO POSITION BURST", 60/301490 and 09/993779 entitled "CIRCUIT AND METHOD FOR DETECTING THE PHASE OF A SERVO SIGNAL", 60/301503 and 09/993778 entitled "SERVO CIRCUIT HAVING A SYNCHRONOUS SERVO CHANNEL AND METHOD FOR SYNCHRONOUSLY RECOVERING SERVO DATA" which were filed on the same day as the present application and which are incorporated by reference.

The invention is related generally to data encoding and decoding, and more particularly to a 1/4 code and a method for coding servo data on a data-storage disk. The 1/4 code allows one to shift an analog dibit data channel into a digital partial response channel. As compared to conventional codes, such a 1/4 code allows an increase in the data-storage capacity of the disk and can improve noise performance during the reading of coded servo data.

As computer-software applications become larger and more data intensive, disk-drive manufacturers are continuing their efforts to develop technologies and techniques for increasing the data-storage capacities of data-storage disks. For example, manufacturers have developed techniques to increase the storage capacities of disks by increasing the densities at which disk-drives write application data onto the disks.

But unfortunately, there are obstacles to increasing a disk's data-storage capacity. For example, because disks are typically constrained to industry-standard sizes, manufacturers often do not have the option of increasing a disk's storage capacity by increasing its size. Moreover, because most non-application data (*e.g*., servo wedges, spin-up wedges, file-allocation tables (FAT)) is necessary for proper operation of a disk drive, the manufacturers often cannot remove this data from a disk to make more room for storage of application data.

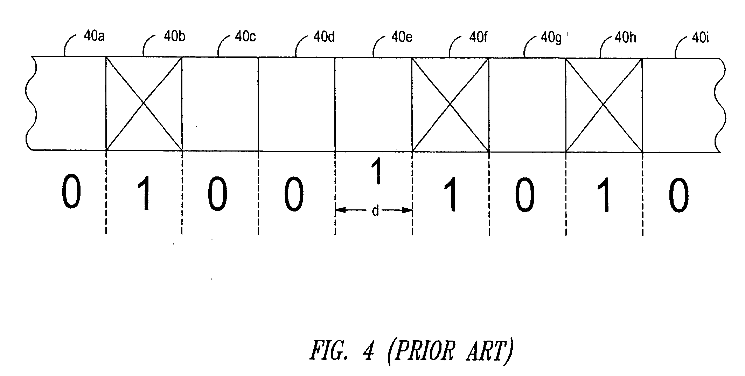

As discussed below in conjunction with **FIG. 4,** a major obstacle to increasing a disk's storage capacity is that it is often impractical for a manufacturer to increase the density of the servo data stored on a disk. To increase the density of the servo data, the manufacturer would have to modify its servo-data writing format. Unfortunately, such modification is often prohibitively expensive and time consuming.

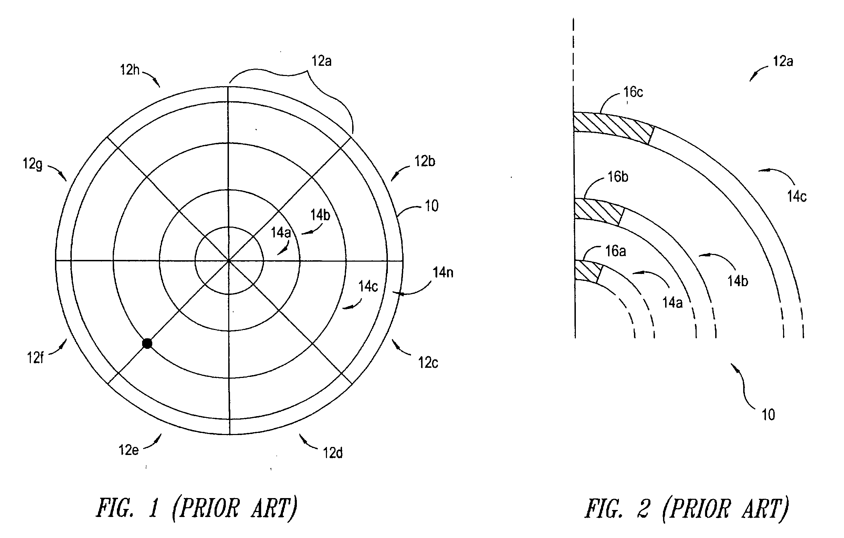

**FIG. 1** is a plan view of a conventional magnetic data-storage disk ***10.*** The disk ***10*** is partitioned into a number ― here eight ― of disk sectors ***12a-12h*,** and includes a number ― typically in the tens or hundreds of thousands ― of concentric data tracks ***14a-14n.*** Readable-writable application data is stored in respective data sectors (not shown) within each track ***14.***

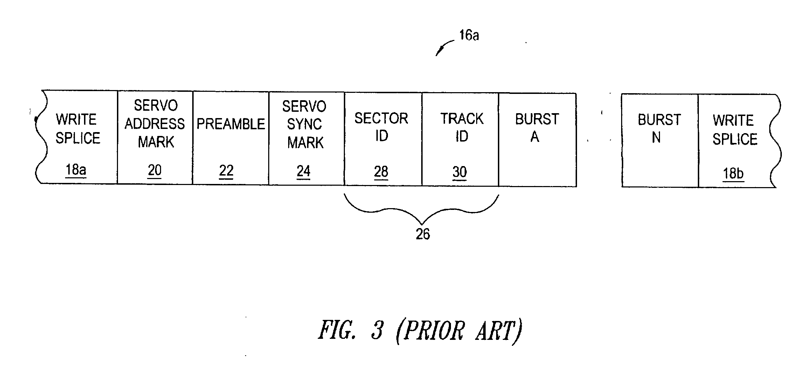

Referring to **FIG. 2,** servo wedges ***16* ―** only servo wedges ***16a*** ― ***16c*** are shown for clarity ― include servo data that has a number of functions. For example, the servo data typically allows a disk drive (not shown in **FIG. 2**) to synchronize a sample clock (not shown) to the servo data, to identify the location of the servo wedge containing the servo data, and to position a read-write head (not shown in FIG. 2) over a track ***14*** during a data read or write operation. The servo wedges ***16*** are located within each track ***14*** at the beginning ― the disk ***10*** spins counterclockwise in this example ― of each disk sector ***12.*** The manufacturer of a disk drive (not shown in **FIG. 2**) that incorporates the disk ***10*** typically writes the servo wedges ***16*** onto the disk before shipping the disk drive to a customer; neither the disk drive nor the customer alters the servo wedges ***16*** thereafter. Furthermore, the servo data in the wedges ***16*** is often coded to increase the reliability with which a servo circuit (not shown in **FIG. 2**) recovers the servo data. Servo wedges like the servo wedges ***16*** are further discussed below in conjunction with **FIG. 3** and in commonly owned U.S. Patent App. Ser. No. 09/783,801 (Atty. Docket No. 99-S-185 (1678-21)), filed February 14, 2001, entitled "VITERBI DETECTOR AND METHOD FOR RECOVERING A BINARY SEQUENCE FROM A READ SIGNAL," which is incorporated by reference.

**[8] FIG. 3** is a diagram of the servo wedge ***16a*** of **FIG. 2,** the other servo wedges ***16*** being similar. Write splices ***18a*** and ***18b*** respectively separate the servo wedge ***16a*** from adjacent data sectors (not shown). An optional servo address mark (SAM) ***20*** indicates to a head-position circuit (not shown in **FIG. 3**) that the read-write head (not shown in **FIG. 3**) is at the beginning of the servo wedge ***16a***. A servo preamble **22** allows a servo circuit (neither shown in **FIG. 3**) to synchronize a sample clock to the servo signal (not shown in **FIG. 3**) generated by the read-write head, and a servo synchronization mark (SSM) ***24*** identifies the beginning of a head-location identifier ***26.*** The preamble ***22*** and SSM ***24*** are discussed in previously incorporated U.S. Patent App. Ser. Nos. (Atty. Docket No. 99-S-190 (1678-22-1)) entitled "DATA-STORAGE DISK HAVING FEW OR NO SPIN-UP WEDGES AND METHOD FOR WRITING SERVO WEDGES ONTO THE DISK," (Atty. Docket No. 01-S-044 (1678-22-2)) entitled "CIRCUIT AND METHOD FOR DETECTING A SERVO WEDGE ON SPIN UP OF A DATA-STORAGE DISK", (Atty. Docket No. 01-S-047 (1678-22-3)) entitled "CIRCUIT AND METHOD FOR DETECTING A SPIN-UP WEDGE AND A CORRESPONDING SERVO WEDGE ON SPIN UP OF A DATA-STORAGE DISK", and (Atty. Docket No. 01-S-054 (1678-49)) entitled "SERVO CIRCUIT HAVING A SYNCHRONOUS SERVO CHANNEL AND METHOD FOR SYNCHRONOUSLY RECOVERING SERVO DATA". The location identifier ***26*** allows the head-position circuit to coarsely determine and adjust the position of the read-write head with respect to the surface of the disk ***10*** (**FIG. 1**). More specifically, the location identifier ***26*** includes a sector identifier ***28*** and a track identifier ***30,*** which respectively identify the disk sector ***12*** and the data track ***14*** ― here the sector ***12a*** and the track ***14a ―*** that contain the servo wedge ***16a.*** Because the head may read the location identifier ***26*** even if the head is not centered over the track ***14a,*** the servo wedge ***16a*** also includes head-position bursts A - N, which allow the head-position circuit to finely determine and adjust the position of the head as discussed in previously incorporated U.S. Patent App. Ser. No. (Atty. Docket No. 01-S-045 (1678-47)) entitled "CIRCUIT AND METHOD FOR DEMODULATING A SERVO POSITION BURST".

**FIG. 4** shows bit regions ***40a - 40i*** of the servo wedge ***16a*** of **FIGS. 2** and **3**, and the corresponding servo data that the regions ***40*** represent, it being understood that the other servo wedges ***16*** have similar bit regions. Respective groups of consecutive regions ***40*** form the SAM 20, preamble 22, and other sections of the servo wedge ***16a.*** Each region ***40*** typically represents a corresponding bit of servo data and is polarized to one of two logic levels ― here "X" denotes logic 1 and a blank denotes logic 0 ― and has a length d, which is inversely proportional to the frequency of the servo data.

Typically, a manufacturer's servo-data writing equipment has a preset writing frequency, and thus a preset value for the length d of each region 40. Therefore, decreasing *d* to increase the frequency, and thus the density, of the servo data would likely require the manufacturer to modify or replace the writing equipment.

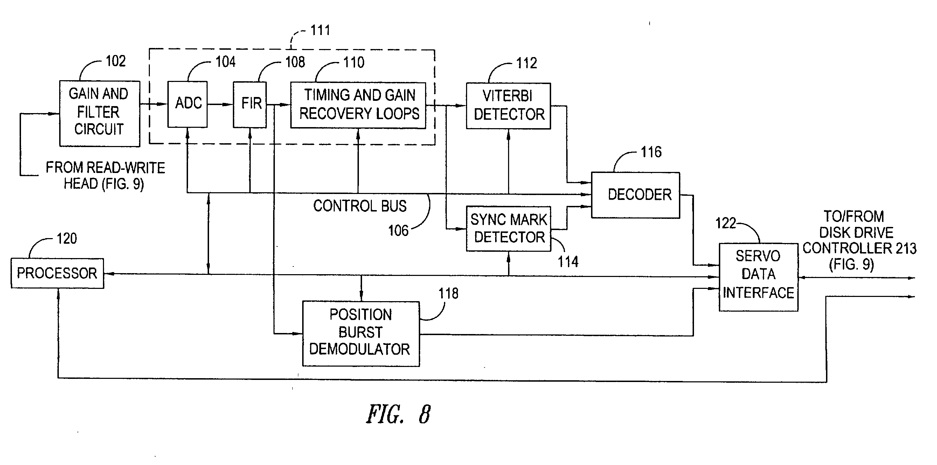

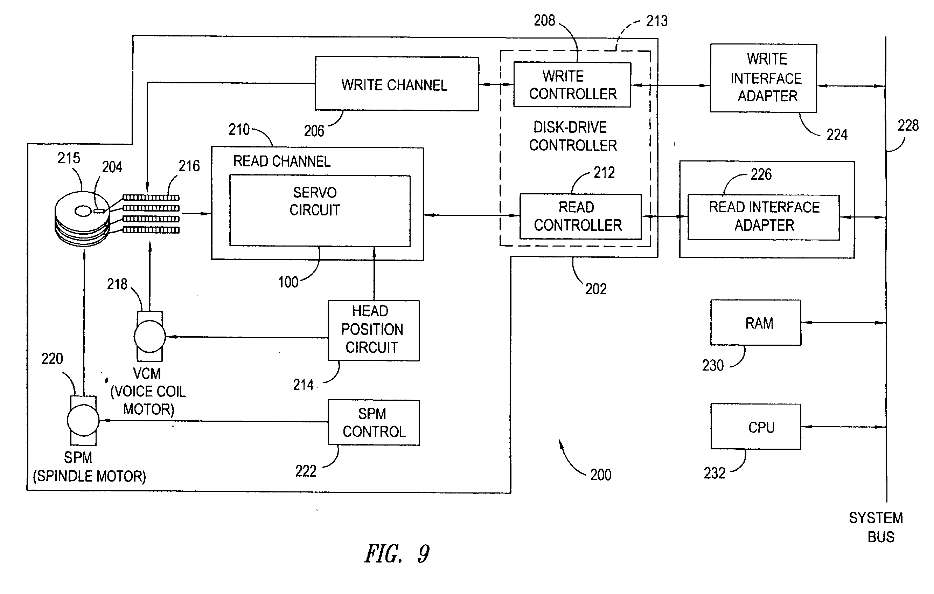

Furthermore, the manufacturer's servo-data writing equipment typically codes the servo data according to a dibit format to facilitate reading of the servo data by a peak detector (not shown) that detects peaks of read signal which represents the data To insure a sufficient number of peaks in the read signal, the regions 40 are typically written such that each pair of regions 40 is either polarized as 00 (*e.g*., regions ***40c*** and ***40d****)* or as 01 (*e.g*., regions ***40e*** and ***40f***). Because a read head (**FIG. 9**) generates a sinusoid, and thus signal peaks, when it reads a 010 sequence of regions 40, this pattern insures the generation of one peak per each region 40 polarized as 1 by surrounding each such region with regions 40 polarized as 0. Consequently, to maintain this pattern, the manufacturer's servo-data writing equipment typically codes a logic 1 as a pair of consecutive regions 40 polarized as 01 and codes a logic 0 as a pair of consecutive regions 40 polarized as 00.

Unfortunately, as discussed above, changing this code would likely be expensive and time consuming because it would likely require the manufacturer to modify the servo-data writing format.

In accordance with an embodiment of the invention, a coded binary sequence includes first and second groups of consecutive bits. The first group has first and second equally sized portions and represents a first logic level. The bits in the first portion each have a second logic level and the bits in the second portion each having a third logic level. The second group also has first and second equally sized portions, and represents a fourth logic level. The bits in the first portion of the second group each have a fifth logic level and the bits in the second portion of the second group each having a sixth logic level. In one example of this embodiment, the first group is 0000 and represents a logic 0, and the second group is 0011 and represents a logic 1.

Such a code is compatible with a conventional dibit code, and thus allows one to read the analog dibit data with a digital PR4 PRML(partial response maximum likelihood) servo channel having a pruned Viterbi detector. Such a servo channel can typically read the dibit data with a much higher performance than the analog peak detector.. Furthermore, such a code allows a manufacturer to increase the storage capacity of a data-storage disk by reducing the space utilized by the servo wedges. Such a code also allows a manufacturer to increase the signal to noise (SNR) performance of a servo circuit while it recovers the servo data.

**FIG. 1** is a plan view of a conventional magnetic data-storage disk having disk sectors and data tracks.

**FIG. 2** is a magnified view of the servo wedges of the disk of **FIG. 1.**

**FIG. 3** is a diagram of a servo wedge of **FIG. 2.**

**FIG. 4** is a magnified view of the servo wedge of **FIG. 3** and the corresponding servo data.

**FIG. 5** shows the correspondence between a sequence of servo data that is coded according to an embodiment of the invention and the bit regions of the servo wedge that contains the coded servo data.

**FIG. 6** is a diagram of servo-data Gray codes (which are not RLL coded) and the corresponding magnetization patterns for track identifiers in adjacent data tracks according to an embodiment of the invention.

**FIG. 7A** is a plot of servo signals corresponding to read-head positions over and between the fourth and fifth data tracks of **FIG. 6** according to an embodiment of the invention.

**FIG. 7B** is a plot of servo signals corresponding to read-head positions over and between the fifth and sixth data tracks of **FIG. 6** according to an embodiment of the invention.

**FIG. 8** is a block diagram of a servo circuit that can recover and decode a sequence of servo data that is coded according to an embodiment of the invention.

**FIG. 9** is a block diagram of a disk-drive system that incorporates the servo circuit of **FIG. 8** according to an embodiment of the invention.

Table I is a one-bit-to-four-bit (1/4) modulated code for coding servo data according to an embodiment of the invention. Although described as for coding servo data, one can use the 1/4 modulated code to code other types of data as well.

**Table I**

| **Servo Logic Level** | **Code Symbol** |
|---|---|
| 0 | 0000 |
| 1 | 0011 |

That is, each servo bit having a logic 0 level is coded as four consecutive logic 0 levels, and each uncoded servo bit having a logic 1 level is coded as two consecutive logic 0 levels followed by two consecutive logic 1 levels. Prior to 1/4 coding, the servo data may be coded with an arbitrary Run Length Limited (RLL) code. That is, if the servo data is to be RLL coded, one RLL codes it first and then codes the RLL-coded servo data with the 1/4 code. Most RLL codes have enough transitions in the code to allow a Viterbi detector (**FIG. 8**) to merge for a successful sequence detection. . For example purposes, the following sequence of uncoded servo data is discussed:
(1) 011100100011
This sequence is coded as the following sequence of 1/4 coded servo data (the spaces are not part of the sequence but are included to highlight the correspondence between code symbols and the uncoded servo bits):
(2) 0000 0011 0011 0011 0000 0000 0011 0000 0000 0000 0011 0011

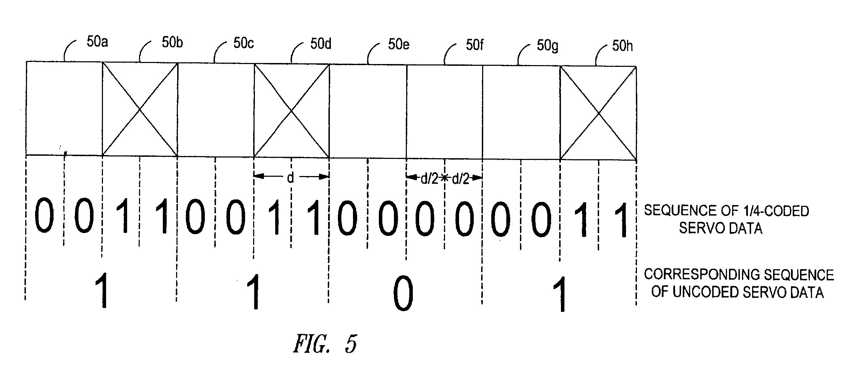

**FIG. 5** is a group of consecutive servo-data bit regions ***50a-50h*** (sometimes called cells) in the servo wedge ***16a*** (**FIG. 2**) and the corresponding sequences of 1/4 coded and uncoded servo data according to an embodiment of the invention. Other than having different values and possibly having different locations within the servo wedge ***16a,*** the regions 50 are similar to the regions ***40*** of **FIG. 4.** As discussed below, the 1/4 code of Table I is compatible with a conventional dibit pattern and can reduce the number of regions ***50*** needed to store coded servo data because each region 50 can store more than one bit.

More specifically, a sequence of servo data coded using the 1/4 code of Table I always has an even number of consecutive logic 0's or an even number of consecutive logic 1's. By taking advantage of the even nature of the code, each pair of 1/4-coded data bits can be written by halving the data. For example, a servo track writer (not shown) can write the 16-bit 1/4-coded sequence 0011001100000011 of FIG. 5 as an 8-bit sequence 01010001. During read back, the 16-bit 1/4-coded sequence can be recovered by sampling each bit of the 8-bit written sequence twice. Therefore, by taking advantage of the data halving provided by the 1/4 code, one can increase the storage capacity of a disk.

Consequently, the 1/4 code is an even code ― and is thus compatible with a conventional dibit pattern ― because each dibit of 0 can be represented as data samples of 0000 and each dibit of 1 can be represented as data samples of 0011. Therefore, manufacturers need not modify their dibit servo-data writing format to use the 1/4 code.

Furthermore, because each region 50 can represent two bits, servo data coded using the 1/4 code of Table I can increase a data-storage disk's (**FIG. 9**) storage capacity because a 1/4-coded sequence occupies less track length, and thus a smaller area of the disk, than a sequence coded according to other codes. For example, commonly owned U.S. Patent 6,201,652 discloses a 4/12 code that encodes each four-bit sequence of servo data as twelve bits. But the 4/12-code bits are such that two consecutive bits may not always be 00 or 11, and, therefore, a 4/12-coded sequence cannot be halved. Therefore, to write four bits of servo data using the 4/12 code requires twelve regions 50. Comparatively, although to write four bits of servo data using the 1/4 code requires sixteen bits, the number of regions 50 can be halved as described above so that the four bits-of 1/4-coded servo data occupy only eight regions 50. Reading the sequence of 1/4-coded servo data, however, entails reading a third (33.3%) more bits (sixteen vs. twelve bits) than reading the 4/12-coded servo data. Assuming that the 1/4-coded data is read back (sampled) at twice the rate at which the 4/12-coded data is read back, it will have an SNR performance of approximately 0.5 db less than the SNR performance of the 4/12-coded data. But if the read-back rate is lowered, the 1/4-coded data can have a better SNR performance than the 4/12-coded data while still occupying less disk space. Therefore, considering the space vs. performance trade off, the 1/4 code is often a better choice for coding servo data than the 4/12 code. Furthermore, the 1/4 code allows a manufacturer to increase the disk storage capacity even for dibit-coded formats.

Still referring to **FIG. 5,** in addition allowing an increase in a disk's (**FIG. 9**) data-storage capacity, the 1/4 code can also increase the robustness of the servo circuit (**FIG. 8**) because a sequence of 1/4-coded servo data includes only pairs of logic 1's that are separated by at least two logic 0's. This characteristic allows one to prune the Viterbi detector (**FIG. 8**) of the servo circuit to "fit" the 1/4 code. This pruning often increases the robustness of the Viterbi detector, and thus the robustness of the servo circuit, by allowing the Viterbi detector to recover servo data from a servo signal having a lower signal-to-noise ratio (SNR) than an unpruned version of the Viterbi detector could tolerate. Examples of pruned Viterbi detectors that can recover 1/4-coded servo data are discussed in U.S. Patent 6,201,652, which is incorporated by reference, and in previously incorporated U.S. Patent App. Ser. No. (Atty. Docket No. 99-S-185 (1678-21)), filed February 14, 2001, entitled "VITERBI DETECTOR AND METHOD FOR RECOVERING A BINARY SEQUENCE FROM A READ SIGNAL." Conversely, if one where to convert the 1/4 code into a standard dibit (1/2) code by making every pair of logic 0's in a sequence of 1/4-coded servo data a single logic 0 and every pair of logic 1's a single logic 1, then one could not prune the Viterbi detector as described in these references. Put another way, effectively converting such a dibit code into the 1/4 code of Table I by sampling each region 50 twice (once per bit) instead of once allows one to prune the Viterbi detector without increasing the area of the disk that the coded servo data occupies.

Because a sequence of 4/12-coded servo data according to U.S. Patent 6,201,652 has the same characteristic ― only pairs of logic 1's that are separated by at least two logic 0's ― as but occupies more disk area than a sequence of 1/4-coded servo data as discussed above, the 4/12-coded data theoretically has better noise performance than the 1/4-coded data. That is, the servo signal that the read head (**FIG. 9**) generates while reading a sequence of 4/12-coded servo data theoretically has a higher SNR ― approximately 0.5 dB higher ― than the servo signal that the read head generates while reading a sequence of 1/4-coded servo data. This higher SNR effectively increases the robustness of the Viterbi detector, and thus the robustness of the servo circuit, for recovering 4/12-coded servo data as compared to recovering 1/4-coded servo data.

But if the manufacturer can spare extra area on the disk (**FIG. 9**), it can increase the noise performance of a sequence of a 1/4-coded servo data beyond that of a sequence of 4/12-coded servo data by writing one bit of 1/4-coded servo data per region 50 instead of two bits per region. Specifically, doubling the length of the sequence of 1/4-coded servo data from 8d (eight regions ***50a-50h***) to 16*d* (not shown in **FIG. 5**) decreases the density, and thus the frequency, of the sequence. Although the 16*d*-long 1/4-coded sequence is a fourth (25%) longer than its 12d-long 4/12-coded counterpart, this increase in length increases the noise performance of the 1/4-coded data by approximately 0.5 dB. That is, the servo signal that the read head (**FIG. 9**) generates while reading this 1/4-coded data theoretically has an SNR that is approximately 0.5 dB higher than the SNR of the servo signal that the read head generates while reading a sequence of 4/12-coded servo data. Consequently, there is a tradeoff between servo-data density and noise performance; the higher the density, the lower the noise performance and vice versa.

Still referring to **FIG. 5,** although the 1/4 code is discussed'as generating sequences of consecutive logic 0's and 1's that can always be divided into an integer number of two-bit groups, other codes can generate sequences of consecutive logic 0's and 1's that can always be divided into an integer number of more-than-two-bit groups. For example, Table II is a 1/6 code that generates coded data having sequences of consecutive logic 0's and 1's that can always be divided into an integer number of three-bit groups.

**Table II**

| **Servo Logic Level** | **Code Symbol** |
|---|---|
| 0 | 000000 |
| 1 | 000111 |

Consequently, each region ***50*** of 1/4-coded servo data could represent three bits (three logic 0's or three logic 1's), and thus the servo circuit (**FIG. 8**) could sample each region 50 three times. But one cannot use the Viterbi detectors discussed in U.S. Patent 6,201,652 and U.S. Patent App. Ser. No. (Atty. Docket No. 99-S-185 (1678-21)), filed February 14, 2001, entitled "VITERBI DETECTOR AND METHOD FOR RECOVERING A BINARY SEQUENCE FROM A READ SIGNAL" to recover a 1/6-coded sequence.

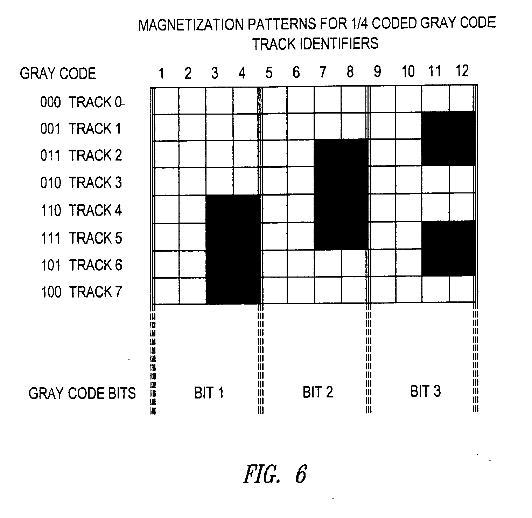

**FIG. 6** is a diagram of the magnetization patterns corresponding to 16-bit Gray code track-identification words formed using the 1/4 code of Table I according to an embodiment of the invention. These code words are respectively stored in the track ID sections ***30*** (**FIG. 3**) of the servo wedges ***16*** (**FIG. 2**) in each group of eight adjacent tracks ***14,*** here labeled tracks 0 - 7. Although these code words as shown are not RLL coded, one typically would RLL code them before 1/4 coding them.

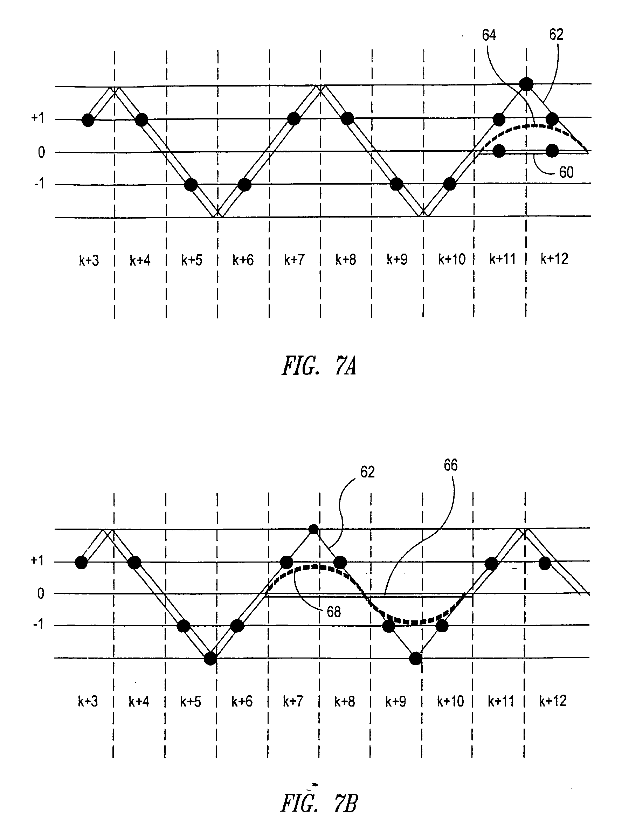

As discussed below in conjunction with **FIGS. 7A** and **7B,** this Gray code coding scheme of **FIG. 6** allows a head-position system (**FIG. 9**) to identify the track ***14*** over which the read-write head (**FIG. 9**) is located within ±1 track, even if the head is positioned between two tracks. To obtain this result, the Gray code coding scheme constrains code changes between adjacent tracks ***14*** to replacement of a single pair of logic 1's (represented by dark squares) with a pair of logic 0's (represented by light squares) or replacement of a single pair of 0's with a pair of 1's. For example, the only change in the code words between tracks 1 and 2 is that bits 7 and 8, which are logic 0's in track 1, are replaced with logic 1's in track 2. Similarly, the only change between tracks 2 and 3 is that bits 11 and 12, which are logic 1's in track 2, are replaced with logic 0's in track 3.

**FIGS. 7A** and **7B** are plots of servo read signals corresponding to tracks 4 - 6 of FIG. 6 according to an embodiment of the invention. As discussed below, the magnetization patterns of **FIG. 6** are such that if the read head **(FIG. 9)** is in between two tracks ***14,*** the servo circuit **(FIG. 8**) ― specifically the Viterbi detector in the servo circuit ― recovers the code word corresponding to one of the two tracks. Consequently, the head-position system (**FIG. 9**) can determine the location of the head within ±1 track accuracy.

**FIG. 7A** is a plot of servo signals corresponding to the head (FIG. 9) being over track 4 or track 5 or in between tracks 4 and 5 of **FIG. 6**. For clarity, the servo signals are ideal, *i.e.,* have no noise component (other than ISI). The y axis represents the amplitude of the servo signal in units of conventional PR4 sample values -1, 0, and +1, and the x axis represents time in units of the samples k of the servo signal. For example, sample time k = 3 corresponds to the sample of the servo signal taken when the read head is aligned with the third bit position (bit 3) of the Gray coded code words stored in tracks 4 and 5 **(FIG. 6).** The head generates the servo signal ***60*** when it is directly over track 4. Similarly, the head generates the servo signal ***62*** when it is directly over track 5. And the head generates the servo signal 64 when it is halfway between tracks 4 and 5.

Still referring to **FIG. 7A,** because the magnetization patterns of tracks 4 and 5 are identical for bits 1 - 10, the signals ***60, 62,*** and ***64*** are virtually identical from sample time k = 3 (k = 1 and 2 not shown) to k = 10. At sample times 11 - 12, the signals ***60,*** ***62**,* and ***64*** are different. Specifically, the signal ***62*** transitions from -1, -1 (samples 9 and 10) to +1, +1 (samples 11 and 12) due to bits 9 and 10 of track 5 being logic 0 and bits 11 and 12 being logic 1. Conversely, because bits 9 - 12 of track 4 are logic 0, there are no flux changes so the signal ***60*** transitions from -1, -1, to 0 and levels out at 0. The signal ***64*** transitions from approximately -1, -1 to +0.5, +0.5, and thus is halfway in between the signals ***60*** and ***62.*** In actuality, the signal **64** is likely to be closer to one of the signals ***60*** and ***62*** than to the other. Therefore, the servo circuit (**FIG. 8**) recovers the coding word associated with the track ― track 4 or track 5 in this example ― closest to the head (**FIG. 9**). The head-position circuit (**FIG. 9**) then uses the information provided by the head-position bursts A - N (**FIG. 3**) in tracks 4 and 5 to precisely position the head over the desired track ― track 4 or track 5 in this example.

**FIG. 7B** is a plot of read signals corresponding to the read head (**FIG. 9**) being over track 5 or track 6 or in between tracks 5 and 6 of **FIG. 6**. The servo signal 62 ― which is identical to the servo signal ***62*** of **FIG. 7A** ― is the signal that the head generates when it is directly over track 5. Similarly, the head generates the servo signal 66 when it is directly over track 6. The head generates the servo signal 68 when it is halfway between tracks 5 and 6. As discussed above in conjunction with **FIG. 7A**, the servo circuit (**FIG. 8**) recovers the Gray coded track-identification word associated with the track ― track 5 or track 6 in this example ― closest to the head, and thus allows the head-position circuit to locate the position of the head with respect to the disk (**FIG. 9**).

**FIG. 8** is block diagram of a synchronous servo circuit ***100,*** which can recover servo data coded using the 1/4 code of Table I according to an embodiment of the invention. The circuit ***100*** includes a gain and filter circuit ***102,*** which adjusts the gain of and filters the servo signal from a read-write head (**FIG. 9**). An analog-to-digital converter (ADC) ***104*** receives a sample clock (not shown) on a control bus ***106*** and generates digital samples, such as the samples k (**FIGS. 7A** and **7B**), of the analog servo signal from the circuit ***102.*** A finite-impulse-response (FIR) filter ***108*** equalizes the samples from the ADC ***104,*** and timing and gain recovery loops ***110*** effectively synchronize the sample clock to the servo signal and maintain the gain of the circuit ***100*** at a desired level. The ADC ***104,*** FIR ***108,*** and loops ***110*** form a sample circuit ***111.*** *A* Viterbi detector ***112*** recovers 1/4-coded servo data such as the location identifier ***26*** (**FIG. 3**) from the servo-signal samples, and an optional sync-mark detector ***114*** recovers the servo sync mark ***24*** (**FIG. 3**) from the servo signal. In one embodiment, the Viterbi detector ***112*** is pruned as discussed above in conjunction with **FIG. 5.** Where the sync-mark detector ***114*** is omitted, the Viterbi detector ***112*** recovers the sync mark ***24.*** A decoder ***116*** decodes the recovered 1/4-coded servo data and sync mark from the Viterbi and sync-mark detectors ***112*** and ***114,*** respectively. A position-burst demodulator ***118*** receives samples of the servo signal from the FIR *108* and generates a head-position-error signal, and a processor ***120*** controls the components of the servo circuit ***100*** via the control bus ***106.*** A servo-data interface ***122*** interfaces the decoder ***116,*** processor ***120,*** and demodulator ***118*** to a disk-drive controller (**FIG. 9**).

Still referring to **FIG. 8,** the circuit ***102,*** ADC ***104,*** FIR ***108*,** loops ***110,*** Viterbi detector ***112,*** decoder ***116,*** processor ***120,*** and operation of the servo circuit ***100*** are further discussed in previously incorporated U.S. Patent App. Ser. Nos. (Atty. Docket No. 99-S-190 (1678-22-1)) entitled "DATA-STORAGE DISK HAVING FEW OR NO SPIN-UP WEDGES AND METHOD FOR WRITING SERVO WEDGES ONTO THE DISK," (Atty. Docket No. 01-S-044 (1678-22-2)) entitled "CIRCUIT AND METHOD FOR DETECTING A SERVO WEDGE ON SPIN UP OF A DATA-STORAGE DISK", (Atty. Docket No. 01-S-047 (1678-22-3)) entitled "CIRCUIT AND METHOD FOR DETECTING A SPIN-UP WEDGE AND A CORRESPONDING SERVO WEDGE ON SPIN UP OF A DATA-STORAGE DISK", (Atty. Docket No. 01-S-054 (1678-49)) entitled "SERVO CIRCUIT HAVING A SYNCHRONOUS SERVO CHANNEL AND METHOD FOR SYNCHRONOUSLY RECOVERING SERVO DATA". The timing-recovery loop of the loops ***110*** is further discussed in commonly owned U.S. Patent App. Ser. No. 09/387,146, filed August 31, 1999, entitled "DIGITAL TIMING RECOVERY USING BAUD RATE SAMPLING", which is incorporated by reference, and the gain-recovery loop of the loops ***110*** and the Viterbi detector ***112*** are also discussed in previously incorporated Patent App. Ser. No. 09/783,801, (Atty. Docket No. 99-S-185 (1678-21)), filed February 14, 2001, entitled "VITERBI DETECTOR AND METHOD FOR RECOVERING A BINARY SEQUENCE FROM A READ SIGNAL". The sync mark detector ***114*** is further discussed in previously incorporated Pat. App. Ser. No. (Atty. Docket No. 01-S-045 (1678-48)) entitled "CIRCUIT AND METHOD FOR DETECTING THE PHASE OF A SERVO SIGNAL" ,and the burst demodulator ***118*** is discussed in previously incorporated U.S. Patent App. Ser. No. (Atty. Docket _ (1678-47) entitled "CIRCUIT AND METHOD FOR DEMODULATING A SERVO POSITION BURST".

**FIG. 9** is a block diagram of a disk-drive system ***200*** that incorporates the servo circuit ***100*** of **FIG. 8** according to an embodiment of the invention. The disk-drive system ***200*** includes a disk drive ***202,*** which incorporates the servo circuit ***100*** of **FIG. 8.** The disk drive ***202*** includes a read-write head ***204,*** a write channel 206 for generating and driving the head ***204*** with a write signal, and a write controller ***208*** for interfacing the write data to the write channel ***206.*** The disk drive ***202*** also includes a read channel ***210*** for receiving servo and application-data read signals from the head ***204*** and for recovering data from these signals, and includes a read controller ***212*** for organizing the read data. Together, the write and read controllers ***208*** and ***212*** compose a disk-drive controller ***213.*** The read channel ***210*** includes the servo circuit ***100,*** which receives the servo signal from the head ***204,*** recovers the servo data from the servo signal, and provides the recovered servo data to a head-position circuit ***214.*** The disk drive ***202*** further includes a storage medium such as one or more disks ***215,*** each of which may contain data on one or both sides and which may be magnetic, optical, or another type of storage disk. For example, the disks ***215*** may be similar to the disk ***10*** of **FIG. 1.** The head ***204*** writes/reads the data stored on the disks ***215,*** and is connected to a movable support arm ***216.*** The head-position circuit ***214*** provides a control signal to a voice-coil motor (VCM) ***218,*** which positionally maintains/radially moves the arm ***216*** so as to positionally maintain/radially move the head ***204*** over the desired data tracks on the disks ***215.*** A spindle motor (SPM) ***220*** and a SPM control circuit ***222*** respectively rotates the disks ***215*** and maintains them at the proper rotational speed.

The disk-drive-system ***200*** also includes write and read interface adapters ***224*** and ***226*** for respectively interfacing the disk-drive controller ***213*** to a system bus ***228,*** which is specific to the system used. Typical system busses include ISA, PCI, S-Bus, Nu-Bus, etc. The system ***200*** typically has other devices, such as a random access memory (RAM) ***230*** and a central processing unit (CPU) ***232*** coupled to the bus ***228.***

From the foregoing it will be appreciated that, although specific embodiments of the invention have been described herein for purposes of illustration, various modifications may be made without deviating from the spirit and scope of the invention.

## Claims

1. A coded binary sequence, comprising:
a first group of consecutive bits, the first group having first and second equally sized portions and representing a first logic level, the bits in the first portion each having a second logic level and the bits in the second portion each having a third logic level; and
a second group of consecutive bits, the second group having first and second equally sized portions and representing a fourth logic level, the bits in the first portion each having a fifth logic level and the bits in the second portion each having a sixth logic level.

2. The binary sequence of claim 1 wherein:
the first and second equally sized portions of the first group respectively comprise first and second halves of the first group; and
the first and second equally sized portions of the second group respectively comprise first and second halves of the second group.

3. A coded binary sequence, comprising:
an first group of consecutive bits each having a first logic level, the first group representing a second logic level; and
a second group of consecutive bits, the second group having first and second portions and representing a third logic level, the bits in the first portion each having a fourth logic level and the bits in the second portion each having a fifth logic level.

4. The binary sequence of claim 3, wherein the first and second groups each respectively comprise four consecutive bits.

5. The binary sequence of claim 3, wherein the first and second portions of the second group respectively comprises first and second halves of the second group.

6. A coded binary sequence, comprising:
a first group of four consecutive bits each having a first logic level the first group representing a second logic level; and
a second group of four consecutive bits respectively having a third logic level, the third logic level, a fourth logic level, and the fourth logic level, the second group representing a fifth logic level.

7. A storage disk, comprising:
disk sectors operable to store application data; and
servo wedges that store servo data that includes ,
a first group of consecutive bits, the first group having first and second equally sized portions and representing a first logic level, the bits in the first portion each having a second logic level and the bits in the second portion each having a third logic level; and
a second group of consecutive bits, the second group having first and second equally sized portions and representing a fourth logic level, the bits in the first portion each having a fifth logic level and the bits in the second portion each having a sixth logic level.

8. A Viterbi detector operable to:
receive a signal that represents a binary sequence having a first group of consecutive bits each having a first logic level and a second group of consecutive bits, the second group having first and second portions, the bits in the first portion having the first logic level and the bits in the second portion having a second logic level, the first group representing the first logic level and the second group representing the second logic level; and
recover the binary sequence from the signal.

9. The Viterbi detector of claim 8 wherein the binary sequence comprises a coded binary sequence.

10. A servo circuit, comprising:
a sample circuit operable to generate samples of a signal that represents a coded binary sequence having a first group of consecutive bits each having a first logic level and a second group of consecutive bits, the second group having first and second portions, the bits in the first portion having the first logic level and the bits in the second portion having a second logic tevel, he first group representing the first logic level and the second group representing the second logic level; and
a Viterbi detector coupled to the sample circuit and operable to recover the coded binary sequence from the samples of the signal.

11. A disk-drive system, comprising:
a data-storage disk having a surface, data sectors at respective locations of the surface, and servo wedges that store servo data that includes a first group of consecutive bits each having a first logic level and a second group having first and second portions of consecutive bits, the bits in the first portion having the first logic level and the bits in the third portion having a second logic level, the first group representing the first logic level and the second group representing the second logic level;
a motor coupled to and operable to rotate the disk;
a read head operable to generate a servo signal that represents the servo data
and having a position with respect to the surface of the data-storage disk; a read-head positioning circuit operable to move the read head over the surface of the disk; and
a servo circuit coupled too the read head and operable to recover the servo data from the servo signal.

12. The disk-drive system of claim 11 wherein the servo circuit comprises: a sample circuit operable to generate samples of the servo signal; and a Viterbi detector coupled to the sample circuit and operable to recover the servo data from the samples of the servo signal.

13. The disk-drive system of claim 11 or circuit of claim 10 wherein the servo circuit comprises a decoder operable to decode the recovered servo data.

14. The disk-drive system of claim 11 wherein the read head comprises a read-write head.

15. A method comprising:
coding a first logic level as a first group of consecutive bits, the first group having first and second equally sized portions, the bits in the first portion each having a second logic level and the bits in the second portion each having a third logic level; and
coding a fourth logic level as a second group of consecutive bits, the second group having first and second equally sized portions, the bits in the first portion each having a fifth logic level and the bits in the second portion each having a sixth logic level.

16. The method of claim 15 or sequence of claims 3 or 6 wherein:
the first, second, third and fifth logic values equal a logic 0; and
the fourth and sixth logic values equal a logic 1; or
the first, second and fourth logic levels equal logic 0,
and the third and fifth logic levels equal logic 1; or
the first, second and third logic values equal a logic 0, and
the fourth and fifth logic values equal a logic 1.

17. The method of claim 20 wherein the coding comprises:
coding the first logic level as a first group of four consecutive bits; and
coding the fourth logic level as a second group of four consecutive bits.

18. The method of claim 15 wherein the first and second portions of the first group and the first and second portions of the second group respectively comprise first and second halves of the first and second groups.

19. A method comprising:
coding a first bit of servo data as a first group of four consecutive bits each having a first logic level; and
coding a second bit of servo data as a second group of four consecutive bits respectively having the first logic level, the first logic level, a second logic level, and the second logic level.

20. The method of claim 19 or detector of claim 13 wherein:
the first logic level equals a logic 0; and
the second logic level equals a logic 1.

21. A method comprising:
writing a first code symbol into a servo wedge of a data-storage disk, the first code symbol having a length and representing the first logic level; and
writing a second code symbol into the servo wedge, the second code symbol having the length or approximately the length, a first portion, and a second portion, and representing a second logic level, the first portion having a different value than the second portion.

22. The method of claim 21 wherein:
the first and second code symbols each comprise a number of code bits; and
the lengths of the first and second code symbols are each less than the product of the number and a length of a servo-bit region.

23. The method of claim 19 or 21 wherein:
the first code symbol or bit represents a logic 0; and
the second code symbol or bit represents a logic 1.

24. The method of claim 21 wherein the first and second portions of the second code symbol are or are approximately half as long as the second code word.
